# EUROPEAN PATENT APPLICATION

(11) **EP 2 224 253 A1**
(43) Date of publication of application: **01.09.2010**
(21) Application number: 09153760.5
(22) Date of filing: 26.02.2009
(51) Int. Cl.: G01R 15/20, B60Q 11/00

(54) **Sensing device**

(71) Applicant: Scambia Industrial Developments AG, 9494 Schaan (LI); ACE Electronique SAS, 73410 Albens (FR)
(72) Inventor: Legrand, Joris, 2400 Mol (BE); Pochic, Serge, 73290 La Motte Servolex (FR); Meltzer, Didier, 66320 Finestret (FR)
(74) Representative: Hoeger, Stellrecht & Partner Patentanwälte

(57) **Abstract**

A device (1) for sensing the presence of a signal in a supply cable (2) of the rear light or lateral light of a tracking vehicle (3), comprises:
- a body part (10) with a sensor (11) mounted thereto, the sensor (11) being capable of sensing the magnetic field generated by an electric current flowing through the supply cable (2);
- fixation means (100,101,102) for fixing the supply cable (2) relative to the sensor (11) at a position where it is able to sens the magnetic field generated by the electric current flowing through the supply cable (2);
- a magnetic sleeve (13,130,131) surrounding the body part (10), the sensor (11) and the supply cable (2).

## Description

The present invention relates to a sensing device and to an apparatus for generating signals in the supply cables of the rear lights or lateral lights of a trailer corresponding to signals in the supply cables of the rear lights or lateral lights of a tracking vehicle to which the trailer is to be coupled in accordance with the respective independent claim.

When a trailer is coupled to a tracking vehicle, e.g. to a car, it is mandatory in most countries that the trailer be equipped with rear lights and/or lateral lights, too, and that these rear lights and/or lateral lights of the trailer are operated in accordance with operation of the rear lights and/or lateral lights of the tracking vehicle. For example, when the driver of the car actuates the brake the rear light of the trailer coupled to the car must indicate the braking action to the traffic behind the trailer.

It is further known to attach sensors to the supply cables of the rear lights of the tracking vehicle, e.g. the car, however, up to now the supply cables have to be stripped in order to allow the sensor to sense the electrical signal of the conductor of the stripped supply cable. This is disadvantageous, since stripping the cable stands for additional expense on one hand, but more importantly the stripped conductor of the supply cable is prone to corrosion and also may negatively affect the overall reliability of the electrical harness. In some instances, it is also necessary to temporarily disconnect the supply cables from the respective rear light to allow the sensor to be installed, or to cut the existing harness and add a Y-connection or a T-connection.

Therefore, there is a need for a sensor which does not have the disadvantages of the prior art sensors. In particular, the sensor should not negatively affect the reliability of the electrical harness nor should it require stripping of the supply cable to prevent the expense of the stripping step and to prevent the stripped conductor from getting corroded.

Accordingly, the present invention suggests a device for sensing the presence of a signal in a supply cable of the rear light or lateral light of a tracking vehicle, the sensing device comprising:
- a body part with a sensor mounted thereto, the sensor being capable of sensing the magnetic field generated by an electric current flowing through the supply cable;
- fixation means for fixing the supply cable relative to the sensor at a position where it is able to measure the magnetic field generated by the electric current flowing through the supply cable (e.g. the sensor can be positioned in the magnetic field generated by the electric current);
- a magnetic sleeve surrounding the body part, the sensor and the supply cable.

Since the sensor of the sensing device according to the invention senses the magnetic field (rather than an electrical field) of the supply cable this sensing can be performed contact-free. The supply cable is fixed relative to the sensor with the aid of fixation means at a position where the magnetic field generated by the electric current flowing through the supply cable can be measured by the sensor. It is no longer necessary to strip the supply cable, thus avoiding the additional expense of the stripping step. Also, corrosion of the stripped conductor or cutting of the conductor and adding a Y-connection or T-connection is prevented. Moreover, there is no danger any more of negatively affecting reliability of the electrical harness. The magnetic sleeve (the term "magnetic slevve" is meant to include both magnetizable and magnetically conductive sleeves) either prevents the sensor from sensing magnetic fields which are not caused by the current flowing through the cable (e.g. the terrestrial magnetic field, or the magnetic field of other cables of the car through which current flows) or allows to compensate for adverse effects (e.g. magnetic remanence) caused by magnetic fields. While this is typically not of particular importance for lamps or bulbs having a power consumption of 21 W, it is of importance for lamps or bulbs having a power consumption of 5 W, and is even more important for LED lamps having a still lower power consumption, since the current flowing through the respective cables in the latter two cases is comparatively low (given the typical 12 V supply voltage of a car). In case of a magnetically conductive sleeve such sleeve forms a magnetic short-circuit for the "external" magnetic fields and thus prevents them from being sensed by the sensor. The sleeve may additionally be made from a magnetically conductive material having substantially no magnetic remanence to avoid any influence of a remanent magnetic field to the total magnetic field within the sleeve which could otherwise lead to falsified sensor signals or must be compensated for.

In one embodiment of the device according to the invention, the magnetic sleeve has a cylindrical shape and comprises a slit extending in the direction of the longitudinal axis of the cylinder. In particular in connection with a further embodiment of the device according to the invention, according to which the body part comprises a protrusion having a width corresponding to the width of the slit in the cylindrically shaped sleeve, it is easily possible to assemble the sensing device by longitudinally moving the sleeve over the body part after the supply cable has been fixed relative to the sensor. The protrusion of the body part serves to guide the sleeve as it is being moved along the longitudinal axis of the cylinder so that after having moved the sleeve over the body part in the aforedescribed manner, the sleeve surrounds the body part, the sensor and the supply cable.

Another aspect of the invention relates to an apparatus for generating signals in the supply cables of the rear lights or lateral lights of a trailer corresponding to signals in the supply cables of the rear lights or lateral lights of a tracking vehicle to which the trailer is to be coupled. The apparatus according to the invention comprises:
- a plurality of sensing devices according to the invention for sensing the presence of a signal in the supply cables of the rear lights or lateral lights of the tracking vehicle, and
- a control unit to which the sensing devices are coupled so as to indicate to the control unit the presence or absence of signals in the supply cables of the rear lights or lateral lights of the tracking vehicle, and to which the corresponding supply cables of the rear lights or lateral lights of the trailer can be coupled.

The sensing devices of the apparatus according to the invention are provided for sensing the magnetic fields of the supply cables of the rear lights or lateral lights of the tracking vehicle, as this has been described above. The sensing devices are coupled to a control unit to indicate to the control unit the presence or absence of a signal in the respective supply cable of the rear light or lateral light of the tracking vehicle. The supply cables of the rear lights or lateral lights of the trailer can be coupled to the control unit so as to allow the control unit to supply the supply cables of the rear lights or the lateral lights of the trailer with corresponding signals.

For example, once the driver of the tracking vehicle, e.g. a car, actuates the brake of the car, the supply cables of the brake light of the car are supplied with current. The magnetic field caused by the current flowing through the respective supply cables of the brake light of the car is sensed by the respective sensors and corresponding signals are forwarded to the control unit. The control unit supplies the respective supply cables of the brake lights of the trailer with current. Of course, it may be sufficient that only one sensor senses a current through the supply cable of one brake light of the tracking vehicle to cause the control unit to supply the supply cables of both brake lights of the trailer with current. Similar considerations may apply to position lights. If a current through only one position light of the tracking vehicle is sensed (e.g. through the left position light), the supply cables of both the left and right positioning lights of the trailer may be supplied with current.

In a specific embodiment of the apparatus according to the invention each sensing device comprises an output signal port being connected to a corresponding input signal port of the control unit. The control unit is connected to a first interface socket to be coupled to a corresponding second interface socket. To the second interface socket the supply cables of the rear lights or lateral lights of the trailer are connected.

This embodiment is particularly advantageous since it allows to easily couple the trailer to the tracking vehicle by coupling the first interface socket to the second interface socket. This can be achieved, for example, by a suitable plug-socket connection in which the first interface socket and the second interface socket are matingly arranged in a predetermined manner so that it is only necessary to connect the first and second interface sockets in a plug-socket manner so as to make sure that the supply cables of the rear lights or lateral lights of the trailer are always properly supplied with current.

Further advantageous aspects of the invention will become apparent from the following description of an embodiment of the invention with the aid of the drawings in which:
- Fig. 1: shows a perspective view of the various components of an embodiment of the sensing device according to the invention in a disassembled state,
- Fig. 2: shows the body part of the sensing device of Fig. 1 with a supply cable,
- Fig. 3: shows the sensing device of Fig. 1 in the assembled state,
- Fig. 4: shows an embodiment of a wheatstone bridge in the sensor of the sensing device, and
- Fig. 5: shows a schematic view of an embodiment of the apparatus according to the invention together with a tracking vehicle and a trailer coupled thereto.

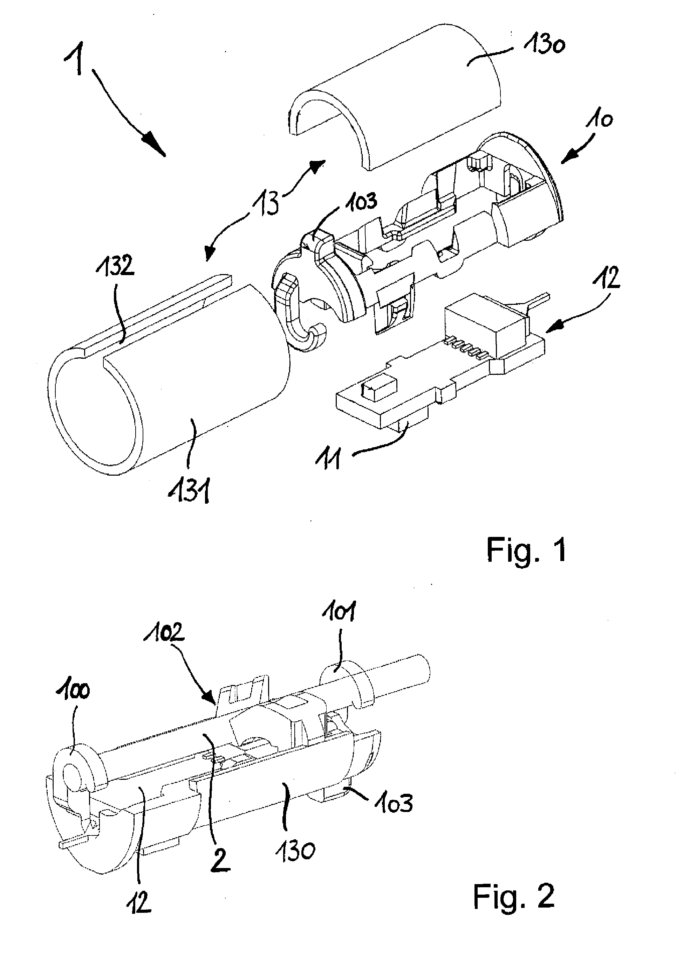

In the perspective view of Fig. 1 the various components of an embodiment of a sensing device 1 according to the invention are shown. Sensing device 1 comprises a body part 10, a sensor 11 capable of sensing a magnetic field and arranged on an electronic circuit board 12, and a magnetic sleeve 13, in this embodiment a magnetically conductive sleeve 13 comprising an inner half-cylindrical shell 130 and an outer cylindrical shell 131.

Body part 10 comprises fixation means which, in the embodiment shown, include two hook-like members 100,101 and a clamping mechanism 102 for fixing a supply cable 2 which is connected to a rear light of a tracking vehicle (not shown) such as e.g. a car. As can be seen in Fig. 2, during assembly of the sensing device, first of all electronic circuit board 12 having the sensor 11 arranged thereon is inserted and attached to body part 10, and inner half-cylindrical shell 130 is to be assembled with body part 10 at the predetermined location, so that the semi-assembled arrangement shown in Fig. 2 is obtained. This semi-assembled arrangement is then mounted to a supply cable 2 of the rear light of the tracking vehicle by hanging the two hook-like members over supply cable 2 and fixedly attaching this semi-assembled arrangement by clamping supply cable 2 with the aid of the resilient clamping mechanism 102. Having done so, supply cable 2 is now fixed relative to sensor 11 at a position such that the magnetic field of an electric current flowing through supply cable 2 can be sensed by sensor 11. Electronic circuit board 12 including sensor 11 mounted thereto is a component which is known *per se* and is available from the company NXP Semiconductors under the name KMZ 51 (of course, suitable components from manufacturers other than NXP Semiconductors can also be used instead). It is to be mentioned that it is not necessary any more to strip supply cable 2, that is to say it is unnecessary to remove any isolation/protective layer surrounding the electrical conductor of supply cable 2. The semi-assembled device (and in the end the entire sensing device, as will be seen below) can be mounted to supply cable 2 in a very convenient manner.

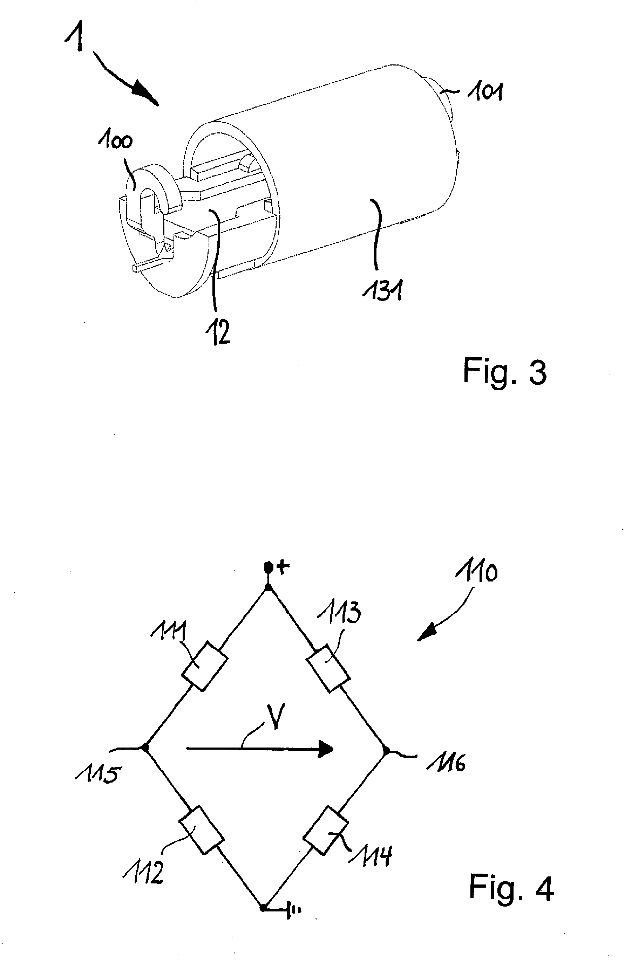

Once the semi-assembled arrangement shown in Fig. 2 has been mounted to supply cable 2, it is only necessary to move outer cylindrical shell 131 over the semi-assembled arrangement for completing assembly and attachment of sensing device 1. To achieve this, outer cylindrical shell 131 is moved over supply cable 2 starting from a location which is axially displaced relative to the semi-assembled arrangement mounted to supply cable 2. This is easily possible since outer cylindrical shell 131 has a longitudinal slit 132 extending in the direction of the longitudinal axis of outer cylindrical shell 131. As can be seen from Fig. 1, body part comprises a protrusion 103 having a width corresponding to the width of the slit in the cylindrically shaped sleeve. Accordingly, as outer cylindrical shell 131 is moved towards and over the semi-assembled arrangement shown in Fig. 2, protrusion 103 serves to guide outer cylindrical shell 131 as it is moved longitudinally over the semi-assembled arrangement until the final assembly of the sensing device shown in Fig. 3 is achieved (supply cable 2 not being shown in Fig. 3). Once again, it is immediately clear that sensing device 1 according to the invention can be mounted to an existing supply cable 2 of a rear light of a tracking vehicle such as a car in a very easy and convenient manner without the need to disconnect the supply cable 2 from the rear light of the car and without the need to strip the conductor of supply cable 2 by removing any isolating/protective layer of supply cable 2.

As has already been explained further above, in particular with respect to lamps or bulbs having a power consumption of 5 W or with respect to LED lamps having a still lower power consumption, "external" magnetic fields should be prevented from being sensed by sensing device 1 since the current flowing through the respective supply cable is comparatively low and, accordingly, the magnetic field caused by this current is comparatively weak (given the typical 12 V supply voltage of a car), so that any "external" magnetic field sensed by sensor 11 could cause sensor 11 to generate a signal where actually there is no such signal present in supply cable 2. To prevent this to occur, sensor 11 is shielded both by inner half-cylindrical shell 130 and by outer cylindrical shell 131 so that no "external" magnetic fields may be sensed by sensor 11.

Also, in case both inner half-cylindrical shell 130 and outer cylindrical shell 131 are made from a material having substantially no magnetic remanence, e.g. from steel, any influence of a remanent magnetic field to the total magnetic field within the sleeve (comprising half-cylindrical inner shell 130 and outer cylindrical shell 131) is avoided. Otherwise, such magnetic remanence must be compensated for (e.g. by means of embedded software) since it could lead to falsified sensor signals. Body part 10 can be made from a plastic material which can be easily manufactured such as e.g. polyethylene or polypropylene and can be manufactured by injection molding. However, this is only by way of example, and of course any other suitable material and manufacturing techniques can be used.

Fig. 4 shows a wheatstone bridge 110 which is intended to improve the understanding of how the sensor signal is generated. The four magneto-resistive components 111,112, 113,114 are chosen such that components 111,114 increase their resistance upon an increase of a magnetic field having a specific orientation which is generated by a current flowing through supply cable 2, while the components 113,112 decrease their resistance upon an increase of the magnetic field of the same specific orientation. Accordingly, a voltage V is generated between the taps 115,116 which is representative of the strength of the magnetic field.

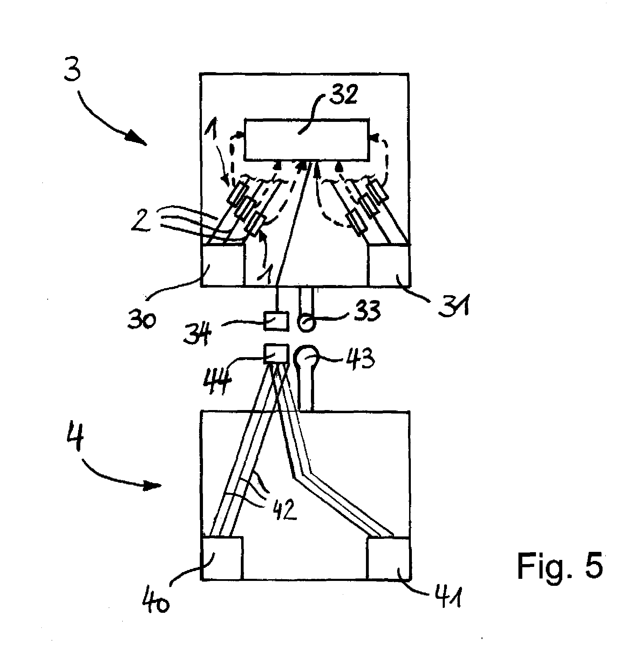

Fig. 5 shows a schematic view of an embodiment of the apparatus according to the invention together with a tracking vehicle 3 and a trailer 4 coupled thereto. Tracking vehicle 3, e.g. a car, comprises two rear lights 30,31 and a plurality of supply cables 2 for supplying the various lamps, bulbs or LEDs of the rear lights 30,31. A control unit 32, e.g. a computer, is provided to the input ports of which the output ports of respective sensing devices 1, which are attached to each of the supply cables 2, are connected (see dashed lines in Fig. 5). The sensing devices 1 are already described above and, therefore, they need not be described again. Control unit 32 is connected to an interface socket 34. Tracking vehicle 3 further comprises a tow ball 33 for mechanically coupling trailer 4 to tracking vehicle 3.

Trailer 4 has a tow bar 43 to be mechanically coupled to towball 33 of the tracking vehicle. Also, trailer 4 has an interface socket 44 corresponding to the interface socket 34 of tracking vehicle 3, so that the two interface sockets 34,44 of tracking vehicle 3 and trailer 4 can be easily connected. To interface socket 44 of trailer 4 the supply cables 42 of the rear lights 40,41 (or the lateral lights, respectively) of trailer 4 are connected.

Once trailer 4 has been mechanically coupled to tracking vehicle 3 and the interface sockets 34,44 have been connected, the apparatus works as follows: Each time a current is supplied through one of the supply cables 2 of the rear lights of the tracking vehicle, e.g. when the driver of the tracking vehicle actuates the brake, sensor 11 of the sensing device 1 coupled to the resepctive supply cable 2 senses the magnetic field generated by the current flowing through the respective supply cable 2. The output port of this sensing device 11 then forwards a corresponding signal to control unit 32. Control unit 32 generates output signals which are forwarded to the respective supply cables 42 of the trailer via the connected interfaces 34,44 , so that the braking action of the tracking vehicle is transferred to the respective rear lights of trailer 4, and the breaking action is indicated to the traffic behind trailer 4 by illumination of the respective lamps, bulbs or LEDs. As already mentioned, sensing of a current through only one of the supply cables of the brake lights of the tracking vehicle may cause control unit 32 to supply current through the supply cables of both brake lights of the trailer.

While a specific embodiment has been described above with the aid of the drawings, many modifications are possible without departing from the spirit of the present invention. Therefore, the scope of protection is intended not to be limited to the specific embodiment described but rather it is intended to be defined by the appended claims.

## Claims

1. Device (1) for sensing the presence of a signal in a supply cable (2) of the rear light or lateral light of a tracking vehicle (3), comprising:
- a body part (10) with a sensor (11) mounted thereto, the sensor (11) being capable of sensing the magnetic field generated by an electric current flowing through the supply cable (2);
- fixation means (100,101,102) for fixing the supply cable (2) relative to the sensor (11) at a position where it is able to measure the magnetic field generated by the electric current flowing through the supply cable (2);
- a magnetic sleeve (13,130,131) surrounding the body part (10), the sensor (11) and the supply cable (2).

2. Device according to claim 1, wherein the magnetic sleeve (131) has a cylindrical shape and comprises a slit (132) extending in the direction of the longitudinal axis of the cylinder.

3. Device according to claim 2, wherein the body part (10) comprises a protrusion (103) having a width corresponding to the width of the slit (132) in the cylindrically shaped sleeve (131) to guide the sleeve (131) as it is being moved along the longitudinal axis of the cylinder so as to surround the body part (10), the sensor (11) and the supply cable (2).

4. Apparatus for generating signals in the supply cables (42) of the rear lights (40,41) or lateral lights of a trailer (4) corresponding to signals in the supply cables (2) of the rear lights (30,31) or lateral lights of a tracking vehicle (3) to which the trailer (4) is to be coupled, the apparatus comprising:
- a plurality of sensing devices (1) according to any one of the preceding claims for sensing the presence of a signal in the supply cables (2) of the rear lights (30,31) or lateral lights of the tracking vehicle (3), and
- a control unit (32) to which the sensing devices (1) are coupled so as to indicate to the control unit (32) the presence or absence of signals in the supply cables (2) of the rear lights (30,31) or lateral lights of the tracking vehicle (3), and to which the corresponding supply cables (42) of the rear lights or lateral lights of the trailer (4) can be coupled.

5. Apparatus according to claim 4, wherein each sensing device (1) comprises an output signal port being connected to a corresponding input signal port of the control unit (32), and wherein further the control unit (32) is connected to a first interface socket (34) to be coupled to a corresponding second interface socket (44) to which the supply cables (42) of the rear lights or lateral lights of the trailer (4) are connected.
